# EUROPÄISCHE PATENTSCHRIFT

(11) **EP 3 347 919 B1**
(45) Veröffentlichungstag und Bekanntmachung des Hinweises auf die Patenterteilung: **13.05.2020**
(21) Anmeldenummer: 16748274.4
(22) Anmeldetag: 15.07.2016
(51) Int. Cl.: H01L 29/94, H01L 49/02

(54) **GRABENKONDENSATOR UND VERFAHREN ZUR HERSTELLUNG EINES GRABENKONDENSATORS**
TRENCH CAPACITOR AND METHOD FOR PRODUCING A TRENCH CAPACITOR
CONDENSATEUR À TRANCHÉE ET PROCÉDÉ DE FABRICATION D'UN CONDENSATEUR À TRANCHÉE

(30) Priorität: 09.09.2015 DE 102015217202
(43) Veröffentlichungstag der Anmeldung: 18.07.2018
(73) Patentinhaber: Robert Bosch GmbH, 70442 Stuttgart (DE)
(72) Erfinder: SCHWAIGER, Stephan, 71229 Leonberg (DE); BANZHAF, Stephanie, 93489 Schorndorf (DE)
(86) Internationale Anmeldenummer: PCT/EP2016/066850
(87) Internationale Veröffentlichungsnummer: WO 2017/041936

(56) Entgegenhaltungen:
- US-A1- 2003 162 368
- US-A1- 2010 224 876
- US-A1- 2014 374 879
- US-B1- 8 963 287

## Beschreibung

### Stand der Technik

Die Erfindung geht von einem Verfahren zur Herstellung eines GrabenKondensators und einem Graben-Kondensator nach der Gattung der unabhängigen Patentansprüche aus.

Silizium- (Si)- Graben-Kondensatoren bieten gegenüber alternativen Kondensator-Technologien den Vorteil, dass sie zum Einen kostengünstig auf Silizium-Substraten hergestellt werden können. Zum Anderen weisen diese bei geeigneter thermischer Anbindung an einen Schaltungsträger eine gute Entwärmung auf. Damit eignen sie sich zur Verwendung in der Leistungselektronik.

Herausforderungen bei der Herstellung dieser Kondensatoren ist die Krümmung der Wafer, welche beim Prozess durch die Abscheidung dielektrischer Schichten zur Isolation auf einer Vorderseite des Substrats bzw. des Wafers entsteht. Je dicker die dielektrischen Schichten abgeschieden werden, desto größer ist die Waferverbiegung, die ab einem gewissen Wert das Prozessieren des Wafers unmöglich macht.

Das Dokument US 2014/0374879 offenbart ein Verfahren zur Herstellung eines Grabenkondensators.

Kern und Vorteile der Erfindung Die Erfindung mit den Merkmalen der unabhängigen Patentansprüche ermöglicht die Herstellung von Halbleiter-, insbesondere Silizium-Graben-Kondensatoren mit dickeren dielektrischen, isolierenden Schichten und damit von Kondensatoren mit erhöhter Spannungsfestigkeit.

Dies wird erfindungsgemäß dadurch erreicht, dass auch auf der Rückseite des Substrats bzw. des Wafers eine Struktur aufgebracht wird, welche einer Verkrümmung des Substrats bzw. des Wafers entgegen wirkt und diese zumindest teilweise kompensiert.

Dazu wird ein Verfahren zur Herstellung eines Grabenkondensators vorgeschlagen mit den Schritten
Bereitstellen eines Substrats, welches eine Vorderseite und eine Rückseite aufweist, Erzeugen einer Gräben aufweisenden Grabenstruktur auf der Vorderseite des Substrats, Aufbringen einer Struktur auf der Rückseite des Substrats, Abscheiden einer isolierenden dielektrischen Schicht auf der Vorderseite und in den Gräben des Substrats, Aufbringen einer ersten Elektrode auf die auf der Vorderseite des Substrats und in der Grabenstruktur abgeschiedene isolierende dielektrische Schicht
Aufbringen einer zweiten Elektrode auf die mit der dielektrischen Struktur versehene Rückseite des Substrats, wobei die dielektrische Struktur Durchbrüche aufweist, so dass die zweite Elektrode im Bereich der Durchbrüche die Rückseite des Substrats kontaktiert.

Die auf der Rückseite des Substrats aufgebrachte Struktur kann vorzugsweise aus demselben Material wie die auf der Vorderseite und in den Gräben des Substrats abgeschiedene dielektrische Schicht bestehen. Damit kann die Struktur vorzugsweise zunächst in Form einer zweiten, dielektrischen Schicht auf der Rückseite des Substrats abgeschieden und in einem weiteren Prozessschritt strukturiert werden. Das Abscheiden der zweiten dielektrischen Schicht kann dabei insbesondere im selben Prozessschritt wie das Abscheiden der dielektischen Schicht auf der Vorderseite des Substrats erfolgen.

Zum Strukturieren der zweiten Schicht ist vorgesehen, dass diese teilweise entfernt wird. Dazu kann vorteilhaft ein Gitterraster auf der zweiten Schicht photolitografisch maskiert und die zweite Schicht anschließend geätzt werden, wobei im Schritt des Ätzens die nicht maskierten Bereiche der zweiten Schicht abgetragen werden, während die maskierten Bereiche der zweiten Schicht erhalten bleiben. Auf diese Weise wird gemäß der vorliegenden Erfindung mit an sich bekannten, gängigen Prozessen eine gitter- oder netzförmige Struktur auf der Rückseite des Substrats erzeugt werden.

Diese gitter- oder netzförmige Struktur, welche vorzugsweise aus demselben Material wie die isolierende, dielektrische Schicht auf der Vorderseite des Substrats besteht, ermöglicht eine zumindest teilweise Kompensation der durch das Aufbringen der isolierenden, dielektrischen Schicht auf die Vorderseite des Substrats entstehenden mechanischen Spannungen. Gleichzeitig ist aber die Rückseite des Substrats weiterhin für eine elektrische Kontaktierung durch die zweite, rückseitige Elektrode zugänglich.

Besonders wirkungsvoll ist die Spannungskompensation dann, wenn die Struktur Netz- oder Gitter-förmig, vorzugsweise mit durchgehendem Gitterlinien in mindestens zwei voneinander verschiedenen Richtungen, ausgebildet ist. Vorteilhaft sind durchgehende Gitterlinien, welche in einem Winkel von 90 Grad zueinander verlaufen oder auch Gitterlinien in drei Flächenrichtungen, welche im Winkel von 60 Grad zueinander verlaufen.

Vorteilhaft ist auch ein Graben-Kondensator, der mit dem erfindungsgemäßen Verfahren hergestellt wird, mit einem eine Vorderseite und eine Rückseite aufweisenden Substrat, einer Gräben umfassenden Grabenstruktur auf der Vorderseite des Substrats, einer auf der Vorderseite und den Oberflächen der Gräben angeordneten isolierenden, dielektrischen Schicht, einer auf der isolierenden, dielektrischen Schicht angeordneten ersten Elektrode, einer auf der Rückseite des Substrats angeordneten Struktur, welche Durchbrüche aufweist und einer auf der Struktur und in den Durchbrüchen der Struktur angeordneten zweiten Elektrode, welche im Bereich der Durchbrüche die Rückseite des Substrats kontaktiert.

### Zeichnungen

Ausführungsbeispiele der Erfindung sind in den Zeichnungen dargestellt und werden nachfolgend näher erläutert. Gleiche Bezugszeichen bezeichnen dabei gleiche oder gleichwirkende Elemente oder Schritte.

Es zeigen
Figur 1 einen Ablaufplan des erfindungsgemäßen Verfahrens,
Figur 2 einen Schnitt durch einen Halbleiter-, beispielsweise Silizium-Graben-Kondensator, welcher mit dem erfindungsgemäßen Verfahren hergestellt ist und
Figur 3 eine Aufsicht auf die Struktur, welche zur Kompensation der durch die auf die Vorderseite des Halbleiter-Substrats aufgebrachte, isolierende dielektrische Schicht in das Substrat induzierten mechanischen Spannung dient und gleichzeitig eine elektrische Kontaktierung des Substrats durch die rückseitige, zweite Elektrode ermöglicht.

### Beschreibung der Ausführungsbeispiele

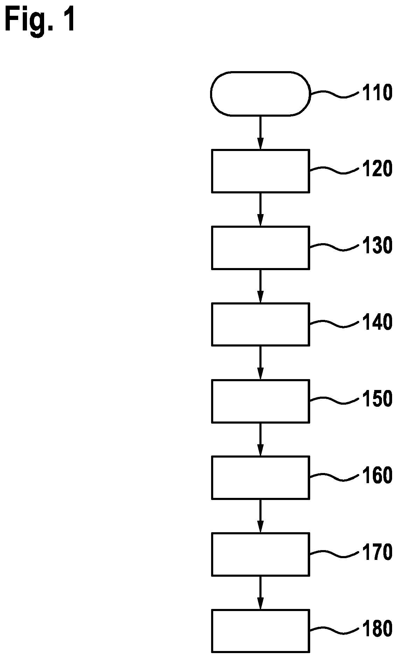

In Figur 1 ist der Ablauf des erfindungsgemäßen Verfahrens anhand eines Ablaufplans skizziert.

Der Ablauf beginnt in Schritt 110.

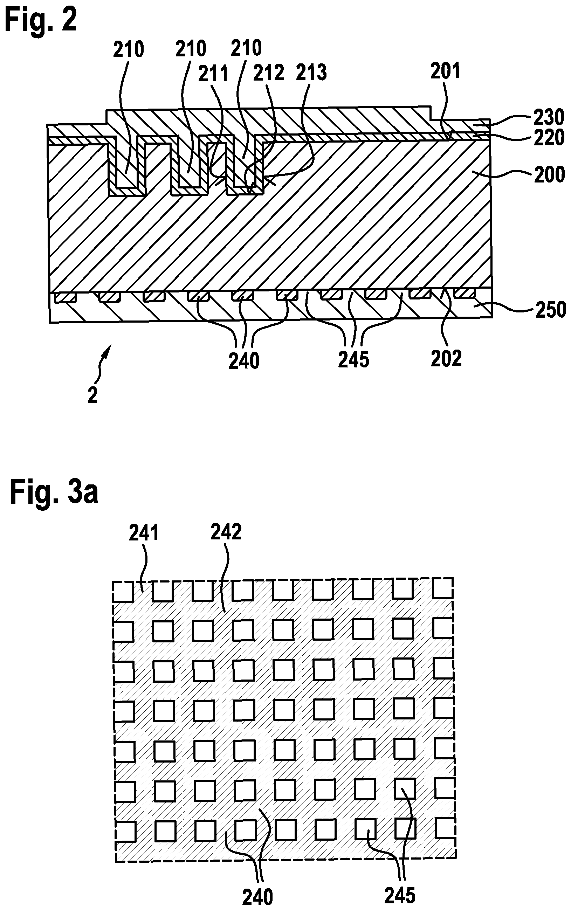

In Schritt 120 wird ein Halbleiter-, hier ein Silizium-Wafer bereitgestellt. Dieser stellt das Substrat 200 (Figur 2) dar, aus dem der erfindungsgemäße Graben-Kondensator 200 nach dem erfindungsgemäßen Verfahren prozessiert wird. Das Substrat 200 weist eine Vorderseite 201 und eine Rückseite 202 auf.

In einem Schritt 130 wird auf eine Vorderseite 201, in der Figur 2 oben, eine Grabenstruktur umfassend eine Mehrzahl von Gräben 210 eingebracht. Dies kann im Wege eines im Bereich der Halbleiter-Fertigung üblichen trockenchemischen Ätzverfahrens erfolgen.

In einem folgenden Schritt 140 wird auf der Vorderseite 201 des Substrats 200 bzw. des Wafers sowie auf den offen liegenden Oberflächen der darin strukturierten Gräben 210, also deren Seitenwänden 211 und 213 sowie deren Böden 212 eine isolierende, dielektrische Schicht 220 aufgebracht. Dies kann beispielsweise mittels eine CVD- (Chemical Vapor Deposition)- oder eines ALD-(Atomic Layer Deposition)- Prozesses erfolgen.

Vorzugsweise im gleichen Schritt 140, alternativ in einem vorhergehenden oder dem Schritt 140 folgenden Prozessschritt 150 wird auf der Rückseite 202 des Substrats 200 ebenfalls eine zweite, isolierende dielektrische Schicht aufgebracht.

Insbesondere auf der Vorderseite 201 des Substrats 200 kann die isolierende Schicht mit gegenüber herkömmlichen Halbleiter- und Silizium-Graben-Kondensatoren deutlich erhöhter Schichtdicke von beispielsweise 0,02 µm - 5 µm ausgeführt werden. Dies wird durch die als Gegenzug fungierende rückseitige, zweite Schicht 240 ermöglicht, welche durch die erste Schicht 220 in das Substrat eingekoppelte mechanische Spannungen insoweit kompensiert, dass eine Verbiegung des Substrats 200 vermieden oder vermindert wird.

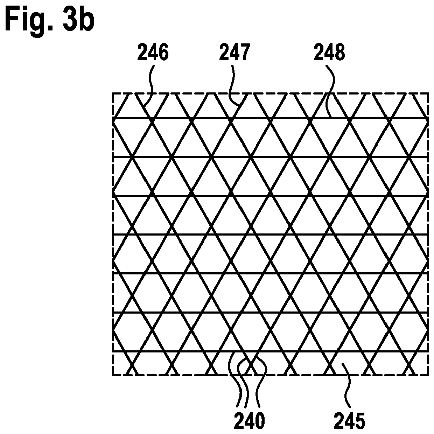

Die auf die Rückseite 202 des Subtrats 200 aufgebrachte, zweite isolierende Schicht 240 wird in einem folgenden Prozessschritt 160 teilweise entfernt, so dass ein Gitter oder Netz aus Maschen 240 (Figuren 3a und 3b) verbleibt, welche freigelegte Inseln 245 der Substrat-Rückseite 202 umgeben. So kann durch Photolithographie beispielsweise ein Fischnetzmuster auf die Rückseite 202 des Substrats 200 aufgebracht werden (Figuren 3a und 3b). Alternativ zum Fischnetzmuster kann auch ein beliebiges anderes periodisches Muster, dessen Gitterkonstante wesentlich kleiner als die Chipgröße ist, verwendet werden. Vorteilhaft ist es, die dielektrische Schicht durchgängig zu gestalten, während die stromleitenden Flächen inselhaft vorliegen können. Diese Anordnungsgeometrie soll den Stressabbau maximieren.

Die zweite dielektrische Schicht 240 wird dazu selektiv an den photolithographisch definierten Stellen 245 entfernt. Jeweils eine Aufsicht der dadurch auf der Rückseite 202 des Substrats 200 gebildeten Struktur 240 ist beispielhaft in den Figuren 3a und 3b dargestellt.

Die Strukturen 240 sind demnach aus einem Gitternetz 240 gebildet, dessen Maschen Durchbrüche 245, auch als Inseln 245 bezeichnet, umschließen. Die Maschen sind dabei durch Stege 241 und 242 (Figur 3a) bzw. 246, 247, 248 (Figur 3b) gebildet. Die Struktur 240 dient der Kompensation einer mechanischen Spannung, welche durch Aufbringen der isolierenden, dielektischen Schicht 220 auf der Vorderseite 201 des Substrats 200 entsteht. Diese mechanische Spannung würde, sofern nicht kompensiert, zu einer Verbiegung des Substrats 200 führen, welche eine weitere Prozessierung bzw. Bearbeitung des Substrats bzw. des soweit hergestellten Halbleiters erschweren oder verhindern würde. Die Verbiegung wird dabei durch die in das Substrat 200 eingebrachten Gräben 210 zusätzlich begünstigt. Die Struktur 240 wirkt dieser Verbiegung entgegen. Besonders wirkungsvoll ist die Struktur 240 hinsichtlich ihrer Spannungskompensation dann, wenn das Netz 240 über durchgehende Stege 241, 242 bzw. 246, 247, 248 verfügt, so dass die Stege über die gesamte Ausdehnung des Substrats 200 mechanische Spannungen aufnehmen können. Besonders wirkungsvoll ist die Stresskompensation darüber hinaus dann, wenn die Flächenrichtungen über die Substrat-Bodenfläche 202 durch die Richtungen der Stege 241, 242 bzw. 246. 247. 248 abgedeckt werden. Im Fall der Figur 3a sind dazu die Stege 241, 242 in einem Winkel von 90 Grad zueinander angeordnet. Die Größenanagabe von 90 Grad ist dabei als Richtwert zu verstehen, von dem auch im Rahmen der Prozessungenauigkeiten abgewichen werden kann. Auch kann grundsätzlich ein abweichender Winkel gewählt werden. Eine abweichende Struktur 240 ist in Figur 3b dargestellt. Hier sind die Stege in einem Winkel von 60 Grad zueinander ausgerichtet.

In einem Prozessschritt 170 wird auf die vorderseitige, erste isolierende dielektrische Schicht 220 eine erste Elektrode 230 aufgebracht. Vorzugsweise im gleichen, alternativ in einem vorhergehenden oder nachfolgenden, Prozessschritt wird auf die Rückseite des Substrats, also auf die Maschen der rückseitigen Struktur 240 sowie die davon umgebenen Inseln 245 der Substrat-Rückseite 202 eine zweite Elektrode 250 aufgebracht.

Im Anschluss werden die so auf dem Wafer prozessierten Kondensatoren zur Einzel-Kondensatoren vereinzelt, beispielsweise mit Laser-Schneiden oder in einem Sägeprozess.

In Figur 2 ist ein Querschnitt durch einen mit dem erfindungsgemäßen Verfahren hergestellten Halbleiter-, hier Silizium-Graben-Kondensator 2 dargestellt. Der Graben-Kondensator 2 verfügt über ein Substrat 200 aus Silizium. Dieses weist typischerweise Abmessungen von [Substratdicke 0,05 mm- 2 mm] auf. Von einer ersten Oberfläche, hier um im Folgenden Vorderseite 201, des Substrats 200 aus sind Gräben 210 in das Substrat 200 eingebracht. Dies erfolgt beispielsweise mittels eines gängigen Halbleiter-Ätzverfahrens.

Auf einer der ersten Oberfläche 201 abgewandten, zweiten Oberfläche, hier und im Folgenden Rückseite 202, des Substrats 200 ist die bereits anhand der Figuren 3a und 3b beschriebene Struktur 240, bestehend aus einem Netz aus isolierendem, dielektrischen Material aufgebracht. Bei dem isolierenden, dielektrischen Material kann es sich beispielsweise um [Siliziumoxid (SiO2), Siliziumnitrid (Si3N4), Aluminiumoxid (Al2O3) handeln. Die Stege 241, 242 bzw. 246, 247, 248 können vorteilhaft die Dimensionen [Periode 1 µm bis 100 µm] aufweisen.

Auf der Vorderseite 201 des Substrats 200 einschließlich der Oberflächen, also der Wandflächen 211 und 213 sowie der Bodenflächen 212 der Gräben 210 ist eine Schicht 220 aus dem isolierenden, dielektrischen Material aufgebracht [Dicke des Dielektrikum: 0,02 µm - 5 µm].

Sowohl auf die Vorderseite des mit der isolierenden Schicht 220 bedeckten Substrats 200, als auch auf die Rückseite 202 des mit der Struktur 240 überspannten Substrats 200 ist schließlich eine elektrische Kontaktierung in Form einer ersten, flächig ausgebildeten Elektrode 230 auf der Vorderseite sowie einer zweiten flächigen Elektrode 250 auf der Rückseite, aufgebracht. Die zweite Elektrode 250 liegt dabei einerseits auf der Struktur 240 und andererseits in den Inseln 245 bzw. Lücken 245 der netzförmigen Struktur 240 unmittelbar auf der Rückseite 202 des Substrats 200 auf.

Somit ist die Struktur 240 zwar hinsichtlich der mechanischen Stresskompensation, im Wesentlichen jedoch nicht elektrisch wirksam. Der Kondensator wird somit hinsichtlich seiner elektrischen Eigenschaften im Wesentlichen durch die Abfolge erste, vorderseitige Elektrode 230, erste isolierende, dielektrische Schicht 220 und Substrat 200 als zweiten Elektrode gebildet. Hierbei wird davon ausgegangen, dass das Substrat 200 elektrisch gut leitfähig ist. Das Substrat kann auch niedrig dotiert (bewusst schlechter leitend) gewählt werden, um einen massgeschneiderten Serienwiderstand in die Struktur zu integrieren.

## Patentansprüche

1. Verfahren zur Herstellung eines Grabenkondensators (2) mit den Schritten Bereitstellen (120) eines Substrats (200), welches eine Vorderseite (201) und eine Rückseite (202) aufweist,
Erzeugen einer Gräben (210) aufweisenden Grabenstruktur auf der Vorderseite (201) des Substrats (200),
Abscheiden (140) einer isolierenden dielektrischen Schicht (220) auf der Vorderseite (201) und in den Gräben (210) des Substrats (200),
Aufbringen (150, 160) einer Struktur (240) auf der Rückseite (202) des Substrats (200),
Aufbringen (170) einer ersten Elektrode (230) auf die auf der Vorderseite (201) des Substrats (200) und in der Grabenstruktur (210) abgeschiedene isolierende, dielektrische Schicht (220),
Aufbringen (170) einer zweiten Elektrode (250) auf die mit der Struktur (240) versehenen Rückseite (202) des Substrats (200)
wobei die Struktur (240) Durchbrüche (245) aufweist, so dass die zweite Elektrode (250) im Bereich der Durchbrüche (245) die Rückseite (202) des Substrats (200) kontaktiert, **dadurch gekennzeichnet, dass** die Struktur (240) eine Netz- oder Gitterstruktur aufweist.

2. Verfahren nach Anspruch 1, wobei die auf die Rückseite (202) des Substrats (200) aufgebrachte Struktur (240) aus demselben Material besteht wie die auf der Vorderseite (201) des Substrats (200) abgeschiedene isolierende dielektrische Schicht (220).

3. Verfahren nach Anspruch 2, wobei die Struktur (240) oder eine zweite Schicht, aus der die Struktur (240) auf der Rückseite (202) des Substrats (200) erzeugt wird, in demselben oder einem unmittelbar benachbarten Prozessschritt wie das Abscheiden der isolierenden dielektrischen Schicht (220) auf der Vorderseite (201) des Substrats (200) erfolgt.

4. Verfahren nach einem der vorhergehenden Ansprüche, wobei die Struktur (240) durch Strukturieren einer auf der Rückseite (202) des Substrats (200) abgeschiedenen zweiten Schicht erzeugt wird.

5. Verfahren nach Anspruch 4, im Schritt des Strukturierens die zweite Schicht teilweise entfernt wird.

6. Verfahren nach Anspruch 5, wobei im Schritt des Strukturierens die zweite Schicht teilweise durch Ätzen entfernt wird und die verbleibende Struktur vor dem Ätzen photolitografisch maskiert wird.

7. Verfahren nach einem der vorhergehenden Ansprüche, wobei die Struktur (240) eine Netz- oder Gitterstruktur mit durchgehendem Gitterlinien in mindestens zwei voneinander verschiedenen Richtungen aufweist.

8. Graben-Kondensator (2), hergestellt nach einem Verfahren nach einem der vorhergehenden Ansprüche, aufweisend
ein eine Vorderseite (201) und eine Rückseite (202) aufweisendes Substrat (200),
eine Gräben (210) umfassende Grabenstruktur auf der Vorderseite (201) des Substrats (200),
eine auf der Vorderseite (201) und den Oberflächen (211, 212, 213) der Gräben (210) angeordnete isolierende, dielektrische Schicht (220),
eine auf der isolierenden, dielektrischen Schicht (220) angeordnete erste Elektrode (230),
eine auf der Rückseite (202) des Substrats (200) angeordnete Struktur (240), welche Durchbrüche (245) aufweist und eine auf der Struktur (240) und in den Durchbrüchen (245) der Struktur angeordnete zweite Elektrode (250), welche im Bereich der Durchbrüche (245) die Rückseite (202) des Substrats (200) kontaktiert, **dadurch gekennzeichnet, dass** die Struktur (240) eine Netz- oder Gitterstruktur aufweist.

## Claims

1. Method for producing a trench capacitor (2) comprising the following steps:
providing (120) a substrate (200) having a front side (201) and a rear side (202),
producing a trench structure having trenches (210) on the front side (201) of the substrate (200),
depositing (140) an insulating dielectric layer (220) on the front side (201) and in the trenches (210) of the substrate (200),
applying (150, 160) a structure (240) on the rear side (202) of the substrate (200),
applying (170) a first electrode (230) to the insulating dielectric layer (220) deposited on the front side (201) of the substrate (200) and in the trench structure (210),
applying (170) a second electrode (250) to the rear side (202) of the substrate (200) provided with the structure (240),
wherein the structure (240) has perforations (245), such that the second electrode (250) contacts the rear side (202) of the substrate (200) in the region of the perforations (245), **characterized in that** the structure (240) has a net or grid structure.

2. Method according to Claim 1, wherein the structure (240) applied to the rear side (202) of the substrate (200) consists of the same material as the insulating dielectric layer (220) deposited on the front side (201) of the substrate (200).

3. Method according to Claim 2, wherein the structure (240) or a second layer, from which the structure (240) is produced on the rear side (202) of the substrate (200), is implemented in the same process step as, or in a process step directly consecutive to, that for depositing the insulating dielectric layer (220) on the front side (201) of the substrate (200).

4. Method according to any of the preceding claims, wherein the structure (240) is produced by structuring a second layer deposited on the rear side (202) of the substrate (200).

5. Method according to Claim 4, the second layer being partly removed in the step of structuring.

6. Method according to Claim 5, wherein in the step of structuring the second layer is partly removed by etching and the remaining structure is masked photolithographically before the etching.

7. Method according to any of the preceding claims, wherein the structure (240) has a net or grid structure having continuous grid lines in at least two mutually different directions.

8. Trench capacitor (2), produced according to a method according to any of the preceding claims, comprising
a substrate (200) having a front side (201) and a rear side (202),
a trench structure comprising trenches (210) on the front side (201) of the substrate (200),
an insulating dielectric layer (220) arranged on the front side (201) and the surfaces (211, 212, 213) of the trenches (210),
a first electrode (230) arranged on the insulating dielectric layer (220),
a structure (240) arranged on the rear side (202) of the substrate (200) and having perforations (245), and a second electrode (250) arranged on the structure (240) and in the perforations (245) of the structure, said second electrode contacting the rear side (202) of the substrate (200) in the region of the perforations (245), **characterized in that** the structure (240) has a net or grid structure.

## Revendications

1. Procédé de fabrication d'un condensateur à tranchée (2), comprenant les étapes consistant à :
fournir (120) un substrat (200) présentant une face avant (201) et une face arrière (202),
produire une structure de tranchées présentant des tranchées (210) sur la face avant (201) du substrat (200),
déposer (140) une couche diélectrique isolante (220) sur la face avant (201) et dans les tranchées (210) du substrat (200),
appliquer (150, 160) une structure (240) sur la face arrière (202) du substrat (200),
appliquer (170) une première électrode (230) sur la couche diélectrique isolante (220) déposée sur la face avant (201) du substrat (200) et dans la structure de tranchées (210),
appliquer (170) une deuxième électrode (250) sur la face arrière (202) du substrat (200) munie de la structure (240),
dans lequel la structure (240) présente des traversées (245) de sorte que la deuxième électrode (250) établit un contact avec la face arrière (202) du substrat (200) au niveau des traversées (245),
**caractérisé en ce que** la structure (240) présente une structure réticulée ou de grille.

2. Procédé selon la revendication 1, dans lequel la structure (240) appliquée sur la face arrière (202) du substrat (200) est composée du même matériau que la couche diélectrique isolante (220) déposée sur la face avant (201) du substrat (200).

3. Procédé selon la revendication 2, dans lequel la structure (240), ou une deuxième couche à partir de laquelle est produite la structure (240) sur la face arrière (202) du substrat (200), est réalisée à la même étape de processus que le dépôt de la couche diélectrique isolante (220) sur la face avant (201) du substrat (200) ou à une étape immédiatement adjacente.

4. Procédé selon l'une quelconque des revendications précédentes, dans lequel la structure (240) est produite en formant des motifs dans une deuxième couche déposée sur la face arrière (202) du substrat (200).

5. Procédé selon la revendication 4, dans lequel la deuxième couche est partiellement retirée à l'étape de formation de motifs.

6. Procédé selon la revendication 5, dans lequel, à l'étape de formation de motifs, la deuxième couche est partiellement retirée par gravure et la structure restante est soumise à un masquage photolithographique avant la gravure.

7. Procédé selon l'une quelconque des revendications précédentes, dans lequel la structure (240) présente une structure réticulée ou de grille avec des lignes de quadrillage continues dans au moins deux directions différentes l'une de l'autre.

8. Condensateur à tranchée (2), fabriqué selon un procédé selon l'une quelconque des revendications précédentes, comprenant
un substrat (200) présentant une face avant (201) et une face arrière (202),
une structure de tranchées présentant des tranchées (210) sur la face avant (201) du substrat (200),
une couche diélectrique isolante (220) disposée sur la face avant (201) et les surfaces (211, 212, 213) des tranchées (210),
une première électrode (230) disposée sur la couche diélectrique isolante (220),
une structure (240) disposée sur la face arrière (202) du substrat (200) et présentant des traversées (245), et une deuxième électrode (250) disposée dans les traversées (245) de la structure qui établit un contact avec la face arrière (202) du substrat (200) au niveau des traversées (245),
**caractérisé en ce que** la structure (240) présente une structure réticulée ou de grille.
